# EUROPEAN PATENT APPLICATION

(11) **EP 4 804 739 A1**
(43) Date of publication of application: **09.09.2026**
(21) Application number: 24885841.7
(22) Date of filing: 31.10.2024
(51) Int. Cl.: H05K 3/46, H01L 23/14, H01L 23/15

(54) **WIRING BOARD AND SEMICONDUCTOR DEVICE**

(30) Priority: 31.10.2023 JP 2023186593; 05.07.2024 JP 2024109137
(71) Applicant: Kyocera Corporation, Kyoto-shi, Kyoto 612-8501 (JP)
(72) Inventor: ITOU, Seiichirou, Kyoto-shi, Kyoto 612-8501 (JP); GONDO, Iori, Kyoto-shi, Kyoto 612-8501 (JP); HARAZONO, Masaaki, Kirishima-shi, Kagoshima 899-4312 (JP)
(74) Representative: Viering, Jentschura & Partner mbB Patent- und Rechtsanwälte
(86) International application number: PCT/JP2024/038933
(87) International publication number: WO 2025/095075

(57) **Abstract**

A wiring board according to the present disclosure includes a first base member made of ceramic, a second base member made of an organic resin and bonded to the first base member, a first wiring line located in the first base member, and a second wiring line located in the second base member. The first wiring line includes a through hole penetrating the first base member, and a conductor including a metal as a main component and located inside the through hole. The through hole is filled with the conductor.

## Description

### TECHNICAL FIELD

The present disclosure relates to a wiring board and a semiconductor device.

### BACKGROUND OF INVENTION

A wiring board is known in which an organic substrate having wiring lines formed thereon is laminated on a glass cloth substrate as a core material.

A through hole portion is formed in the glass cloth substrate. The through hole portion includes a through hole penetrating the glass cloth substrate, a plating film covering an inner wall of the through hole, and a resin filling the through hole (see Patent Document 1).

### CITATION LIST

### PATENT LITERATURE

Patent Document 1: JP 2023-111608 A

### SUMMARY

A wiring board according to an aspect of the present disclosure includes a first base member made of ceramic, a second base member made of an organic resin and bonded to the first base member, a first wiring line located in the first base member, and a second wiring line located in the second base member. The first wiring line includes a through hole penetrating the first base member, and a conductor including a metal as a main component and located inside the through hole. The through hole is filled with the conductor.

### BRIEF DESCRIPTION OF THE DRAWINGS

FIG. 1 is a schematic cross-sectional view illustrating a state in which a semiconductor device according to an embodiment is mounted over a motherboard.
FIG. 2 is a schematic cross-sectional view illustrating a configuration of a wiring board according to an embodiment.
FIG. 3 is an enlarged schematic view of a region III illustrated in FIG. 2.
FIG. 4 is an enlarged schematic view of a region IV illustrated in FIG. 2.
FIG. 5 is an enlarged cross-sectional view illustrating another example of a wiring board according to an embodiment.

### DESCRIPTION OF EMBODIMENTS

Modes (hereinafter, referred to as "embodiments") for implementing a wiring board and a semiconductor device according to the present disclosure are described in detail below with reference to the drawings. Note that the present disclosure is not limited by the embodiments. The embodiments can be appropriately combined within a range that does not cause inconsistencies in the processing content. In the following embodiments, the same portions are denoted by the same reference signs, and redundant descriptions are omitted.

In the following embodiments, expressions such as "certain", "orthogonal", "perpendicular", and "parallel" may be used, but these expressions need not mean exactly "certain", "orthogonal", "perpendicular", and "parallel". In other words, each of the expressions described above allows for deviations in, for example, manufacturing accuracy, or installation accuracy.

In the drawings to be referenced below, to facilitate understanding, an orthogonal coordinate system may be defined, in which the X-axis direction, Y-axis direction, and Z-axis direction mutually orthogonal are specified, and the Z-axis positive direction is set as the vertically upward direction.

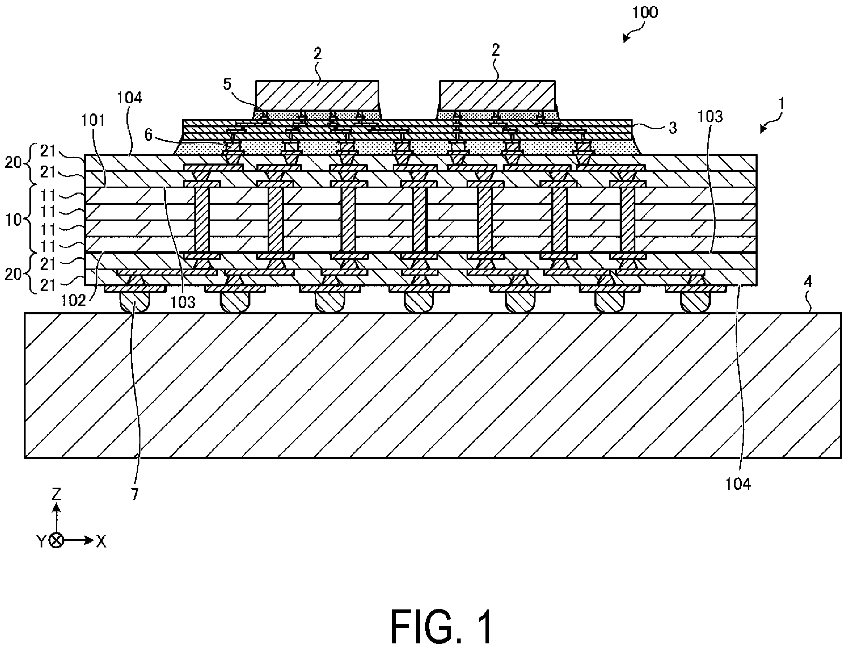

First, a configuration of a semiconductor device 100 according to an embodiment is described with reference to FIG. 1. FIG. 1 is a schematic cross-sectional view illustrating a state in which the semiconductor device 100 according to an embodiment is mounted over a motherboard 4.

As illustrated in FIG. 1, the semiconductor device 100 includes a wiring board 1, a plurality of semiconductor elements 2, and a relay substrate 3.

The wiring board 1 is mounted over the motherboard 4. The wiring board 1 according to the embodiment includes, as a core material, a base member made of ceramic. Details of the wiring board 1 are described below.

The semiconductor element 2 is mounted over the wiring board 1 via the relay substrate 3. The semiconductor element 2 is, for example, a chip or a chiplet in which a circuit or an element is formed on a substrate made of a material other than a semiconductor, such as a semiconductor chip or a glass substrate. A chiplet is a functional block constituting a part of an integrated circuit of the semiconductor device 100.

Although FIG. 1 illustrates two semiconductor elements 2, the semiconductor device 100 may include three or more semiconductor elements. The semiconductor device 100 may include only one semiconductor element 2. For example, when the semiconductor element 2 is a chiplet, an integrated circuit having one function may be configured by a plurality of semiconductor elements 2.

The relay substrate 3 is a so-called interposer, and relays electrical connection between the wiring board 1 and the semiconductor element 2. The relay substrate 3 is bonded to the semiconductor element 2 via bonding portions 5 and is bonded to the wiring board 1 via bonding portions 6. The bonding portions 5 and 6 are, for example, solder. The Young's modulus of the relay substrate 3 may be smaller than the Young's modulus of the wiring board 1. In this case, the relay substrate 3 may have flexibility that allows the relay substrate 3 to be deformed according to the shape of a surface of the wiring board 1.

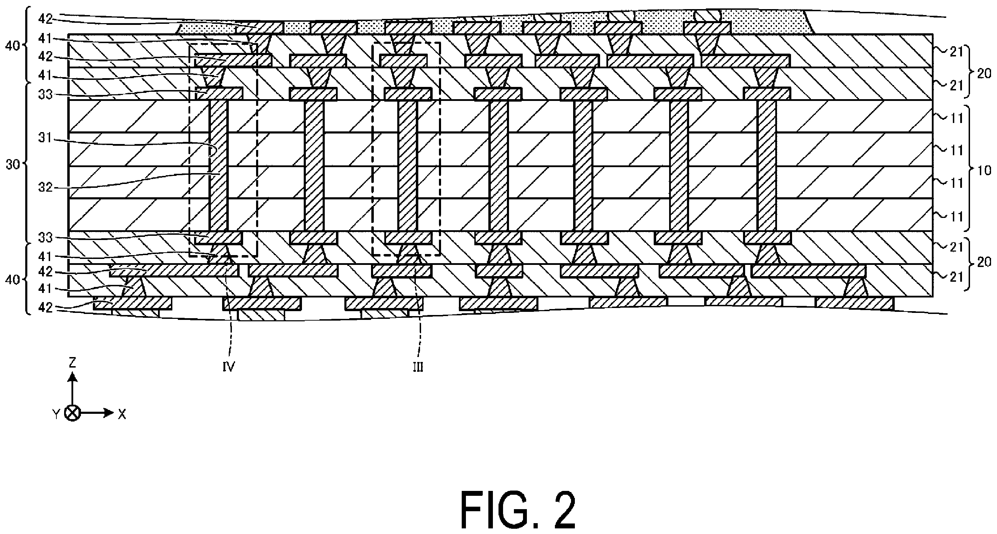

The configuration of the wiring board 1 according to the embodiment is described with reference to FIG. 2. FIG. 2 is a schematic cross-sectional view illustrating the configuration of the wiring board 1 according to the embodiment.

The wiring board 1 includes a first base member 10 and a second base member 20. The wiring board 1 is a laminate body of the first base member 10 and the second base member 20. The wiring board 1 includes a first wiring line 30 and a second wiring line 40.

### First Base Member

The first base member 10 is a base member made of ceramic. The first base member 10 may be formed using a ceramic composite material containing a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles.

For example, the first base member 10 may be low temperature co-fired ceramics (LTCC). When LTCC is used as the first base member 10, a metal having a low melting point such as copper or silver having a relatively low electric resistance can be used as the wiring line. In the present embodiment, the metal having a low melting point is a metal having a lower melting point than a general metal used for a wiring line of a ceramic base member, for example, tungsten or molybdenum.

The first base member 10 may include a ceramic filler as the ceramic particles. As the ceramic filler, for example, alumina (aluminum oxide), calcium titanate, magnesium titanate, or the like can be used. In particular, the first base member 10 including alumina has a high rigidity.

The first base member 10 includes a first surface 101 and a second surface 102 opposite to the first surface 101. The first base member 10 may be a plate-shaped body having the first surface 101 and the second surface 102 as main surfaces.

In the embodiment, the first base member 10 includes a plurality of ceramic layers 11. The plurality of ceramic layers 11 are layered along the thickness direction of the first base member 10. The wiring board 1 including such a first base member 10 has a high degree of freedom in design. By configuring the first base member 10 using the plurality of ceramic layers 11, the first base member 10 can be produced while checking whether the first wiring line 30 is appropriately formed for each layer, so that the yield of the first base member 10 can be improved.

In the example illustrated in FIGs. 1 and 2, the first base member 10 includes four ceramic layers 11; however, the number of the ceramic layers 11 is not limited to four. The number of the ceramic layers 11 may be two or three, or may be five or more.

### Second Base Member

The second base member 20 is a base member including an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE), or other fluororesin or polyphenylene ether resin. The second base member 20 may include a component other than the organic resin. In the present disclosure, the organic resin may be, for example, a material that accounts for 30 mass% or more of the material constituting the second base member 20.

The second base member 20 includes a third surface 103 and a fourth surface 104 opposite to the third surface 103. The second base member 20 may be a plate-shaped body having the third surface 103 and the fourth surface 104 as main surfaces.

The wiring board 1 according to the embodiment includes two second base members 20. One of the two second base members 20 is bonded to the first surface 101 of the first base member 10, and the other is bonded to the second surface 102 of the first base member 10.

The second base member 20 located on the first surface 101 of the first base member 10 includes the third surface 103 bonded to the first surface 101 of the first base member 10, and the plurality of semiconductor elements 2 are mounted on the fourth surface 104 of the second base member 20 via the relay substrate 3 (see FIG. 1).

The second base member 20 located on the second surface 102 of the first base member 10 includes the third surface 103 bonded to the first surface 101 of the first base member 10, and the fourth surface 104 of the second base member 20 is bonded to the motherboard 4 via bonding portions 7.

The second base member 20 includes a plurality of organic resin layers 21. The plurality of organic resin layers 21 are layered along the thickness direction of the second base member 20. The wiring board 1 including such a second base member 20 has a high degree of freedom in design. In the example illustrated in FIG. 2, the second base member 20 includes two organic resin layers 21; however, the number of the organic resin layers 21 is not limited to two. The number of the organic resin layers 21 may be one, or may be three or more.

In the example illustrated in FIGs. 1 and 2, the wiring board 1 includes the second base member 20 on each of both main surfaces (the first surface 101 and the second surface 102) of the first base member 10. The wiring board 1 is not limited thereto, and may include the second base member 20 on at least the first surface 101 of the first base member 10.

The second base member 20 including an organic component is more likely to form a fine wiring pattern than an inorganic substrate. On the other hand, the first base member 10 made of ceramic has a higher rigidity than the second base member 20 and a lower density than the second base member 20.

The wiring board 1 according to the embodiment can increase the rigidity while achieving miniaturization and a narrow pitch of the wiring line by combining the first base member 10 and the second base member 20. Since the warpage of the substrate is more likely to be actualized as the substrate becomes larger, the configuration of the wiring board 1 in which the low rigidity of the second base member 20 is compensated for by the first base member 10 is particularly useful in increasing the size of the substrate.

The first base member 10 and the second base member 20 are bonded to each other by, for example, hydrogen bonding. Specifically, the first base member 10 and the second base member 20 are bonded to each other by bonding the hydroxyl groups of the first base member 10 and the second base member 20 to each other. In this case, a ceramic material such as alumina having a surface hydroxyl group may be used for the first base member 10, and an epoxy resin, which is a resin material including a hydroxyl group, may be used for the second base member 20. In this manner, the first base member 10 and the second base member 20 are directly bonded to each other without solder, underfill, or the like interposed therebetween, so that the thickness of the wiring board 1 can be suppressed and the manufacturing process can be facilitated.

### First wiring line

The first wiring line 30 is a through-hole conductor located in the first base member 10. Specifically, the first wiring line 30 includes a through hole 31 penetrating the first base member 10 and a conductor 32. The conductor 32 includes a metal as a main component and is located inside the through hole 31.

The first wiring line 30 includes a land 33 on the first surface 101 and the second surface 102 of the first base member 10. Details of the first wiring line 30 are described below.

### Second wiring line

The second wiring line 40 includes a plurality of vias 41 and one or more wiring layers 42. The via 41 penetrates one or more organic resin layers 21. The wiring layer 42 is located between the adjacent organic resin layers 21 and electrically connects the plurality of vias 41. The second wiring line 40 may include a land portion located on the fourth surface 104 of the second base member 20.

The first wiring line 30 and the second wiring line 40 may be, for example, metal conductors including copper or silver as a main component. For example, both the first wiring line 30 and the second wiring line 40 may be metal conductors including copper as a main component. Both the first wiring line 30 and the second wiring line 40 may be metal conductors including silver as a main component. One of the first wiring line 30 and the second wiring line 40 may be a metal conductor including copper as a main component, and the other may be a metal conductor including silver as a main component.

By using a metal conductor including copper or silver as a main component for all of the first wiring line 30 and the second wiring line 40, high electrical characteristics can be obtained compared to a case where, for example, one of the first wiring line 30 and the second wiring line 40 is a metal conductor other than copper and silver.

The second wiring line 40 may be electrically and thermally connected to the semiconductor element 2 via the relay substrate 3. The second wiring line 40 including copper or silver having a relatively high thermal conductivity as a main component is thermally connected to the semiconductor element 2 serving as a heat source, so that heat generated from the semiconductor element 2 can be efficiently released via the second wiring line 40 and the first wiring line 30.

Patent Document 1 discloses a wiring board in which a through hole formed in a glass cloth substrate is filled with a resin. The thermal expansion coefficient of the resin is higher than the thermal expansion coefficient of the glass cloth substrate, and the difference is relatively large. Therefore, when the temperature of the wiring board increases, the resin protrudes from the through hole due to thermal expansion, and the protruding resin pushes up the wiring line on the organic substrate, so that the electrical conduction between the wiring line on the organic substrate and the plating film may become insufficient. Since a resin filler has a relatively low strength, maintaining the strength of the glass cloth substrate becomes more difficult as the number of the through hole portions formed in the glass cloth substrate increases.

In the wiring board 1 according to the embodiment, the through hole 31 formed in the first base member 10 is filled with the conductor 32 including a metal as a main component. The conductor 32 including a metal as a main component has a lower thermal expansion coefficient than a resin filler. The difference in thermal expansion coefficient between the first base member 10 made of ceramic and the conductor 32 including a metal as a main component is smaller than the difference in thermal expansion coefficient between the glass cloth substrate and the resin filler. Therefore, even though the conductor 32 thermally expands, the conductor 32 is less likely to push up the second wiring line 40 and the electrical conduction between the second wiring line 40 and the first wiring line 30 is less likely to be interrupted, as compared to the wiring board of the related art. Accordingly, the wiring board 1 according to the embodiment has high electrical reliability.

In the wiring board of the related art, in a case where a via included in the wiring line on the organic substrate is located at a position shifted from the position immediately above the through hole, when the resin filler thermally expands, since a force of the thermally expanded filler pushing up the via is concentrated on one side of the via, the wiring line on the organic substrate is likely to be peeled off. In contrast, in the wiring board 1 according to the embodiment, since the force of the first wiring line 30 pushing up the second wiring line 40 is less likely to occur, when the second wiring line 40 includes a via, even though the via is located at a position shifted from the position immediately above the through hole, the second wiring line 40 is less likely to be peeled off. Accordingly, the wiring board 1 according to the embodiment has a higher degree of freedom in designing the wiring line than the wiring board of the related art.

Since the resin filler has a relatively low strength, maintaining the strength of the glass cloth substrate becomes more difficult as the number of the first wiring lines increases. In contrast, in the wiring board 1 according to the embodiment, since the inner portion of the through hole 31 is filled with the conductor 32 made of metal, the strength of the first base member 10 is easily maintained even when the number of the first wiring lines 30 formed on the first base member 10 increases, compared to the wiring board of the related art. Accordingly, the wiring board 1 according to the embodiment has a high degree of freedom in designing the wiring line.

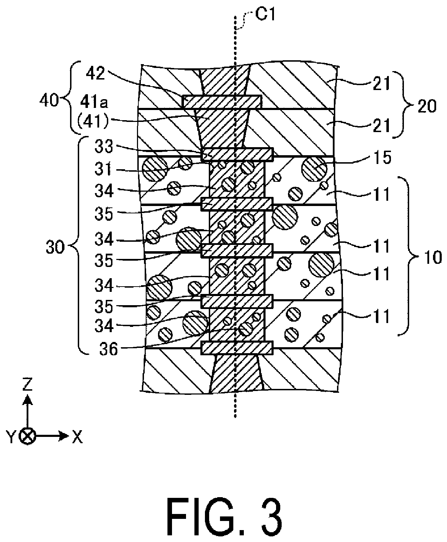

Subsequently, a detailed configuration of the first wiring line 30 according to the embodiment is described with reference to FIG. 3. FIG. 3 is an enlarged schematic view of a region III illustrated in FIG. 2. FIG. 3 illustrates the first wiring line 30 located in the center portion of the wiring board 1 according to the embodiment.

As illustrated in FIG. 3, the conductor 32 (see FIG. 2) includes a plurality of vias 34 and a plurality of lands 35. The via 34 is filled in the through hole 31. For example, a metal conductor including copper as a main component may be used for the via 34. A metal conductor including silver or aluminum as a main component may be used for the via 34. The land 35 is located around the through hole 31 between two adjacent ceramic layers 11.

By positioning the land 35 in this manner, the land 35 is caught by the ceramic layer when the conductor 32 thermally expands, and the via 34 is further less likely to protrude from the first base member 10. Accordingly, the force pushing up the second wiring line 40 is more difficult to occur than in the wiring board of the related art.

The conductor 32 of the first wiring line 30 may contain a glass component 36. In other words, out of the first wiring line 30 and the second wiring line 40, only the first wiring line 30 may contain the glass component 36. According to such a configuration, the first base member 10 and the conductor 32 are firmly bonded to each other via the glass component 36, so that a gap is less likely to be formed between the through hole 31 of the first base member 10 and the conductor 32 and moisture is less likely to enter the inner portion of the first base member 10. Since the conductor (copper) including the glass component 36 has a smaller thermal expansion coefficient than the conductor (copper) not containing the glass component, the force pushing up the second wiring line 40 is further less likely to occur.

When the conductor 32 of the first wiring line 30 contains the glass component 36, in a firing step in the production of the wiring board 1, the shrinkage rates of the first base member 10 and the first wiring line 30 can be made uniform to some extent, which can help prevent a position shift of the first wiring line 30.

The first wiring line 30 may be formed by, for example, screen-printing a conductor paste containing copper and a glass component on a green sheet that is a raw material of the ceramic layer 11 and simultaneously firing the conductor paste and the green sheet. Specifically, the conductor paste may contain, for example, copper powder, borosilicate glass powder, and silica particles.

On the other hand, the second wiring line 40 may be formed by copper plating. Thus, out of the first wiring line 30 and the second wiring line 40, only the first wiring line 30 may contain a glass component.

As described above, the first base member 10 includes the plurality of ceramic layers 11. When a glass core is formed to be thick in order to increase rigidity of the wiring board of the related art, the through hole of the glass core cannot be filled well with a conductor by plating treatment because of the entry of bubbles. In contrast, in accordance with the wiring board 1 according to the embodiment, since the first base member 10 is configured using the plurality of ceramic layers 11 and the conductor 32 is embedded in each ceramic layer, even when the first base member 10 is formed to be thick in order to increase the rigidity, the through hole 31 is easily filled with the conductor 32.

A decrease in the bonding force at the outer peripheral portion between the first base member 10 and the second base member 20 becomes more significant as the wiring board 1 is larger. According to the wiring board 1 having the above effect, since the second wiring line is less likely to be pushed up at the outer peripheral portion, the wiring board 1 can be easily increased in size as compared to the wiring board 1 of the related art.

The via 41 located closest to the first base member 10 among the plurality of vias 41 included in the second wiring line 40 may be located at a position shifted from the through hole 31 of the first base member 10 in plan view. For example, in the example illustrated in FIG. 3, the via 41a located closest to the first base member 10 is located at a position shifted from the through hole 31 of the first base member 10 in the negative X-axis direction.

In the wiring board 1 according to the embodiment, the second wiring line 40 is less likely to peel off, so that the via 41 of the second wiring line 40 can be easily disposed at a position shifted from the position immediately above the through hole 31. Accordingly, the wiring board 1 according to the embodiment has a higher degree of freedom in designing the wiring line than the wiring board of the related art.

As illustrated in FIG. 3, the first base member 10 may contain the glass component 15, and the second base member 20 may contain a coupling agent that chemically bonds to the glass component 15. The glass component 15 is, for example, silica. As the coupling agent, for example, a silane coupling agent can be used. As the coupling agent, a titanium-based coupling agent or an aluminum-based coupling agent can also be used. According to such a configuration, the first base member 10 and the second base member 20, which are different materials, can be more firmly bonded to each other by chemically bonding the first base member 10 and the second base member 20.

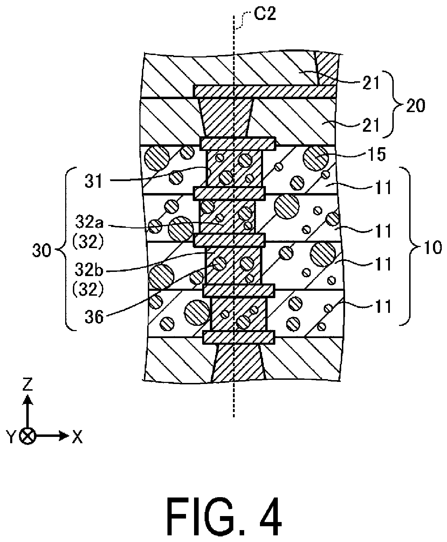

FIG. 4 is an enlarged schematic view of a region IV illustrated in FIG. 2. FIG. 4 illustrates the configuration of the first wiring line 30 located in the outer peripheral portion of the wiring board 1 according to the embodiment.

As illustrated in FIG. 4, in the conductor 32, a conductor portion located in one ceramic layer 11 of the plurality of ceramic layers 11 and a conductor portion located in another ceramic layer 11 adjacent to the one ceramic layer may be shifted from each other in the in-plane direction of the first base member 10. In the example illustrated in FIG. 4, a conductor portion 32a located in one ceramic layer 11 and a conductor portion 32b located in another ceramic layer 11 adjacent to the one ceramic layer 11 are shifted from each other in the X-axis direction that is the in-plane direction of the first base member 10, and the conductor 32 has play. The through holes 31 located in the outer peripheral portion of the wiring board 1 are also formed with the same play as the conductor 32.

Since the conductor 32 has such play, the conductor 32 is caught by the ceramic layer 11 when the conductor 32 thermally expands, and the conductor 32 is further less likely to protrude from the first base member 10. Accordingly, the force pushing up the second wiring line 40 is less likely to occur as compared to the wiring board of the related art.

As illustrated in FIGs. 3 and 4, the straightness of the first wiring line 30 located in the outer peripheral portion of the first base member 10 is smaller than the straightness of the first wiring line 30 located in the center portion of the first base member 10. The straightness is a degree of deviation from an imaginary straight line along the axial direction (Z-axis direction) of the first wiring line 30. In the present specification, "larger straightness" means that the deviation from the imaginary straight line is small, that is, the first wiring 30 is located more linearly. On the other hand, "smaller straightness" means that the deviation from the imaginary straight line is large.

Specifically, as illustrated in FIG. 3, the first wiring line 30 located in the center portion of the first base member 10 is less shifted from an imaginary straight line C1 along the axial direction (Z-axis direction) of the first wiring line 30. That is, the straightness of the first wiring line 30 in the center portion of the first base member 10 is large. On the other hand, as illustrated in FIG. 4, the first wiring line 30 located in the outer peripheral portion of the first base member 10 is greatly shifted from an imaginary straight line C2 along the axial direction (the Z-axis direction) of the first wiring line 30. That is, the straightness of the first wiring line 30 in the outer peripheral portion of the first base member 10 is small. Accordingly, the straightness of the first wiring line 30 located in the outer peripheral portion of the first base member 10 is smaller than the straightness of the first wiring line 30 located in the center portion of the first base member 10.

The bonding force between the first base member 10 and the second base member 20 tends to be weaker at the outer peripheral portion of the first base member 10 than at the center portion of the first base member 10. In accordance with the wiring board 1 according to the embodiment, by making the straightness of the first wiring line 30 located in the center portion of the first base member 10 relatively large, good electrical conduction is ensured, and by making the straightness of the first wiring line 30 located in the outer peripheral portion relatively small, the force pushing up the second wiring line 40 can be made less likely to occur at the outer peripheral portion where the bonding force between the first base member and the second base member is relatively weak, in other words, where the second wiring line 40 is likely to peel off.

### Other Embodiments

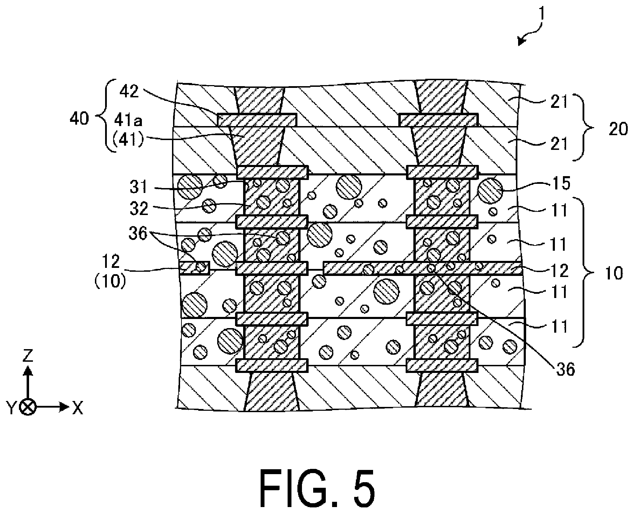

FIG. 5 is an enlarged cross-sectional view illustrating another example of the wiring board 1 according to the embodiment. As illustrated in FIG. 5, the first base member 10 may include an interlayer wiring line 12. In the present disclosure, since the first base member 10 is formed by stacking the plurality of ceramic layers 11, the interlayer wiring line 12 is easily disposed between the adjacent ceramic layers 11. The interlayer wiring line 12 may be, for example, a wiring line for power supply or a wiring line for ground. As illustrated in FIG. 5, in the wiring board 1, the first base member 10 includes the interlayer wiring line 12 as a wiring line for ground in addition to the conductor 32. The interlayer wiring line 12 may contain the glass component 36, similarly to the conductor 32. This improves the bonding strength between the ceramic layer 11 and the interlayer wiring line 12.

Note that the present technique can also have the following configurations.
(1)
   A wiring board (for example, the wiring board 1) includes a first base member (for example, the first base member 10) made of ceramic, a second base member (for example, the second base member 20) made of an organic resin and bonded to the first base member, a first wiring line (for example, the first wiring line 30) located in the first base member, and a second wiring line (for example, the second wiring line 40) located in the second base member. The first wiring line includes a through hole (for example, the through hole 31) penetrating the first base member and a conductor (for example, the conductor 32) including a metal as a main component and located inside the through hole. The through hole is filled with the conductor.
(2)
   In the wiring board according to (1), the conductor may contain a glass component (for example, the glass component 36).
(3)
   In the wiring board according to (1) or (2), the first base member may include a plurality of ceramic layers (for example, the ceramic layers 11).
(4)
   In the wiring board according to (3), in the conductor, a conductor portion (for example, the conductor portion 32a) located in one ceramic layer of the plurality of ceramic layers and a conductor portion (for example, the conductor portion 32b) located in another ceramic layer adjacent to the one ceramic layer may be shifted from each other in an in-plane direction of the first base member.
(5)
   The wiring board according to (1) may include a plurality of first wiring lines, and straightness of the first wiring line located in an outer peripheral portion of the first base member among the plurality of first wiring lines is smaller than straightness of the first wiring line located in a center portion of the first base member among the plurality of first wiring lines.
(6)
   In the wiring board according to (3), the conductor may include a via (for example, the via 34) filled in the through hole, and a land (for example, the land 35) located around the through hole between two adjacent ceramic layers of the plurality of ceramic layers.
(7)
   In the wiring board according to any one of (1) to (6), the second base member may include a plurality of organic resin layers (for example, the organic resin layers 21), and the second wiring line may include a plurality of vias (for example, the vias 41) penetrating one or more of the plurality of organic resin layers and a wiring layer (for example, the wiring layer 42) electrically connecting the plurality of vias to each other and located between adjacent organic resin layers of the plurality of organic resin layers.
(8)
   In the wiring board according to (7), a via (for example, the via 41a) located closest to the first base member among the plurality of vias included in the second wiring line may be located at a position shifted from the through hole of the first base member in plan view.
(9)
   In the wiring board according to any one of (1) to (8), the first base member may contain a glass component (for example, the glass component 15), and the second base member may contain a coupling agent chemically bonding with the glass component.
(10)
   A semiconductor device (for example, the semiconductor device 100) may include the wiring board according to any one of (1) to (9), and a semiconductor element mounted on the second base member of the wiring board.

The embodiments disclosed herein should be considered exemplary in all respects and not restrictive. The embodiments described above may be embodied in various forms. The above-described embodiments may be omitted, substituted, or modified in various forms without departing from the scope and spirit of the appended claims.

### REFERENCE SIGNS

1 Wiring board
2 Semiconductor element
3 Relay substrate
10 First base member
11 Ceramic layer
15 Glass component
20 Second base member
21 Organic resin layer
30 First wiring line
31 Through hole
32 Conductor
36 Glass component
40 Second wiring line
41 Via
42 Wiring layer
100 Semiconductor device

## Claims

1. A wiring board comprising:
a first base member made of ceramic;
a second base member made of an organic resin and bonded to the first base member;
a first wiring line located in the first base member; and
a second wiring line located in the second base member,
wherein the first wiring line comprises:
a through hole penetrating the first base member; and
a conductor comprising a metal as a main component and located inside the through hole, and
the through hole is filled with the conductor.

2. The wiring board according to claim 1, wherein the conductor contains a glass component.

3. The wiring board according to claim 1 or 2, wherein the first base member comprises a plurality of ceramic layers.

4. The wiring board according to claim 3, wherein in the conductor, a conductor portion located in one ceramic layer of the plurality of ceramic layers and a conductor portion located in another ceramic layer adjacent to the one ceramic layer are shifted from each other in an in-plane direction of the first base member.

5. The wiring board according to claim 3 or 4, comprising:
a plurality of the first wiring lines,
wherein straightness of the first wiring line located in an outer peripheral portion of the first base member among the plurality of first wiring lines is smaller than straightness of the first wiring line located in a center portion of the first base member among the plurality of first wiring lines.

6. The wiring board according to any one of claims 3 to 5,
wherein the conductor comprises:
a via filled in the through hole; and
a land located around the through hole between two adjacent ceramic layers of the plurality of ceramic layers.

7. The wiring board according to any one of claims 1 to 6,
wherein the second base member comprises a plurality of organic resin layers, and
the second wiring line comprises a plurality of vias penetrating one or more of the plurality of organic resin layers and a wiring layer electrically connecting the plurality of vias to each other and located between adjacent organic resin layers of the plurality of organic resin layers.

8. The wiring board according to claim 7, wherein the via located closest to the first base member among the plurality of vias comprised in the second wiring line is located at a position shifted from the through hole of the first base member in plan view.

9. The wiring board according to any one of claims 1 to 8,
wherein the first base member contains a glass component, and
the second base member contains a coupling agent chemically bonding with the glass component.

10. A semiconductor device comprising:
the wiring board according to any one of claims 1 to 9; and
a semiconductor element mounted over the second base member of the wiring board.
